# EUROPEAN PATENT APPLICATION

(11) **EP 3 330 402 A1**
(43) Date of publication of application: **06.06.2018**
(21) Application number: 16841467.0
(22) Date of filing: 12.08.2016
(51) Int. Cl.: C23C 14/06, B23B 27/14

(54) **HARD COATING AND HARD COATING-COVERED MEMBER**

(30) Priority: 28.08.2015 JP 2015168794
(71) Applicant: Kabushiki Kaisha Kobe Seiko Sho (Kobe Steel, Ltd.), Kobe-shi, Hyogo 651-8585 (JP)
(72) Inventor: NII, Hiroaki, Nishi-ku, Kobe-shi Hyogo 651-2271 (JP); YAMAMOTO, Kenji, Nishi-ku, Kobe-shi Hyogo 651-2271 (JP)
(74) Representative: Müller-Boré & Partner Patentanwälte PartG mbB
(86) International application number: PCT/JP2016/073765
(87) International publication number: WO 2017/038435

(57) **Abstract**

A hard coating 1 is a hard coating 1 to be formed on a base material 3. The hard coating 1 includes a first layer 11. A composition formula of the first layer 11 is Zr_{1-a-b}HfₐMg_{b}(BₓC_{y}N_{1-x-y}). In this composition formula, a, b, x, y are the respective atomic ratios of Hf, Mg, B, C, and relational expressions of 0 ≤ a ≤ 0.95, 0.05 ≤ b ≤ 0.30, 0 < 1-x-y are satisfied. A hard coating-covered member 10 comprises the base material 3 which is a blade edge portion of a cutting tool and the hard coating 1 which is formed on the base material 3.

## Description

### Technical Field

The present invention relates to a hard coating and a hard coating-covered member including the same.

### Background Art

Conventionally, there has been known a technique in which, in jigs and tools such as a cutting tool, a metal mold and the like, a hard coating is formed as a wear resistant coating for life improvement. Techniques regarding the formation of this hard coating are disclosed in Patent Literatures 1 and 2. Patent Literature 1 discloses a technique in which a hard coating made of nitride containing zirconium or hafnium is formed on a cermet parent material by a chemical vapor deposition method. Patent Literature 2 discloses a technique in which a zirconium-containing film having a twin crystal structure is formed as a hard coating on a tool surface.

The hard coatings disclosed in Patent Literatures 1 and 2 contribute to an improvement of durability and wear resistance of a cutting tool. However, these hard coatings cannot sufficiently improve the wear resistance when they are formed on a surface of a cutting tool for cutting a titanium-based metal such as pure titanium, a titanium alloy and the like, so that these hard coatings cannot sufficiently function as wear resistant coatings.

### Citation List

### Patent Literatures

Patent Literature 1: JP H5-222551 A
Patent Literature 2: JP 2003-39207 A

### Summary of Invention

An object of the present invention is to provide a hard coating suitable for wear resistant coating in jigs and tools for processing a titanium-based metal, and a hard coating-covered member including the same.

A hard coating according to one aspect of the present invention is a hard coating to be formed on a base material, and includes a first layer. A composition formula of the first layer is Zr_{1-a-b}HfₐMg_{b}(BₓC_{y}N_{1-x-y}). In the composition formula of Zr_{1-a-b}HfₐMg_{b}(BₓC_{y}N_{1-x-y}), a, b, x, y are respective atomic ratios of Hf, Mg, B, C, and relational expressions of 0 ≤ a ≤ 0.95, 0.05 ≤ b ≤ 0.30 and 0 < 1-x-y are satisfied.

A hard coating according to an another aspect of the present invention is a hard coating to be formed on a base material, and includes a first layer containing at least one of Zr and Hf. A composition formula of the first layer is Zr_{1-a-b-c}HfₐMg_{b}M_{c}(BₓC_{y}N_{1-x-y}). In the composition formula of Zr_{1-a-b-c}HfₐMg_{b}M_{c}(BₓC_{y}N_{1-x-y}), M is one or more elements selected from the group consisting of W, Mo, Nb and V, a, b, c, x, y are respective atomic ratios of Hf, Mg, M, B, C, and relational expressions of 0 ≤ a ≤ 0.95, 0.05 ≤ b ≤ 0.30, 0 < c, 0 < 1-x-y are satisfied.

### Brief Description of Drawings

FIG. 1 is a perspective view showing a hard coating-covered member according to a first embodiment of the present invention.
FIG. 2 is a schematic view showing a hard coating according to the first embodiment of the present invention.
FIG. 3 is a schematic view showing cutting and processing using the hard coating-covered member.
FIG. 4 is a device view showing a configuration of a coating formation device used for formation of the hard coating.
FIG. 5 is a schematic view showing a hard coating according to a second embodiment of the present invention.
FIG. 6 is a schematic view showing a hard coating according to a modification of the first embodiment.
FIG. 7 is a schematic view showing wear of the hard coating.
FIG. 8 is a schematic view showing a hard coating according to a modification of the second embodiment.

### Description of Embodiments

Hereinafter, embodiments of the present invention will be described in detail with reference to the drawings.

First, an outline of a hard coating and a hard coating-covered member according to the embodiments of the present invention will be described.

A hard coating according to one embodiment of the present invention is a hard coating to be formed on a base material, and includes a first layer. A composition formula of the first layer is Zr_{1-a-b}HfₐMg_{b}(BₓC_{y}N_{1-x-y}). In the composition formula of Zr_{1-a-b}HfₐMg_{b}(BₓC_{y}N_{1-x-y}), a, b, x, y are respective atomic ratios of Hf, Mg, B, C. In the first layer, relational expressions of 0 ≤ a ≤ 0.95, 0.05 ≤ b ≤ 0.30 and 0 < 1-x-y are satisfied.

The present inventors have keenly examined a composition of a hard coating to be formed on a tool surface in order to provide an excellent wear resistant coating layer used for jogs and tools for processing a titanium-based metal. As a result, the present inventors have found that introducing a proper amount of magnesium (Mg), which does not dissolve in titanium (Ti), into the hard coating suppresses an adhesion between the hard coating and a workpiece, so that wear resistance of the hard coating is remarkably improved.

Mg is introduced into the hard coating so that the atomic ratio b is 0.05 or more. This can prevent Mg in the hard coating and Ti in the workpiece from dissolving, and can suppress the adhesion between the hard coating and the workpiece. As a result, the wear of the hard coating due to the adhesion can be suppressed. The atomic ratio b is preferably 0.08 or more, and more preferably, 0.10 or more.

Mg is introduced into the hard coating so that the atomic ratio b is 0.30 or less. This can restrain the coating from being softened due to excessively contained Mg, and a decreasing of the wear resistance is suppressed. The atomic ration b is preferably 0.25 or less, and more preferably, 0.20 or less.

The hard coating contains at least one of Zr and Hf. While Zr and Hf are transition metal elements in group 4 of the periodic table like Ti, they generate more thermodynamically stable nitrides (ZrN, HfN) or oxides as compared with Ti. In a hard coating containing TiN, TiN reacts in an active newly-formed surface formed on a surface of the workpiece during processing. In contrast, since ZrN and HfN are stable compounds in the hard coating, the reaction in the newly-formed surface is suppressed, so that a decrease in wear resistance can be suppressed. Introduction amounts of Zr and Hf are decided based on the above-described introduction amount of Mg, and 0.70 ≤ (Zr + Hf) ≤ 0.95 is satisfied. While any one of Zr and Hf may be 0, (Zr + Hf) > 0 is satisfied.

A hard coating according to an another embodiment of the present invention is a hard coating to be formed on a base material, and includes a first layer containing at least one of Zr and Hf. A composition formula of the first layer is Zr_{1-a-b-c}HfₐMg_{b}M_{c}(BₓC_{y}N_{1-x-y}). In the composition formula of Zr_{1-a-b-c}HfₐMg_{b}M_{c}(BₓC_{y}N_{1-x-y}), M is one or more elements selected from the group consisting of W, Mo, Nb and V, and a, b, c, x, y are respective atomic ratios of Hf, Mg, M, B, C. In the first layer, relational expressions of 0 ≤ a ≤ 0.95, 0.05 ≤ b ≤ 0.30, 0 < c, 0 < 1-x-y are satisfied.

The present inventors have keenly examined the composition of the hard coating in more detail in order to further improve the wear resistance of the hard coating to be formed as the wear resistant coating on the surface of the tool for processing the titanium-based metal. As a result, the present inventors have found that an element M (tungsten (W), molybdenum (Mo), niobium (Nb), vanadium (V)) that generates an oxide having lubricity can be further introduced into the hard coating.

The element M that is one or more elements selected from the group consisting of W, Mo, Nb and V are introduced into the hard coating. These elements generate the oxide having lubricity on a wear surface during processing, which can improve an adhesion resistance of the hard coating to the workpiece. As a result, the wear of the hard coating due to the adhesion can be suppressed. The element M may be one element selected from the group consisting of W, Mo, Nb and V, or may be two or more elements selected from the group.

In the hard coating, preferably, a relational expression of 0 < c ≤ 0.50 is satisfied in the first layer. As described above, introducing the element M (the atomic ratio c is set to 0 < c) allows the oxide having lubricity to be generated, which improves the adhesion resistance of the hard coating. In order to sufficiently exert this effect, 0.10 ≤ c is preferable, 0.15 ≤ c is more preferable, and 0.20 ≤ c is still more preferable.

On the other hand, when the atomic ratio c of the element M exceeds 0.50, amounts of ZrN and HfN, which are stable compounds, relatively decrease, so that a wear speed of the coating becomes fast. Therefore, the atomic ratio c is c ≤ 0.50, preferably c ≤ 0.40, and still more preferably c ≤ 0.30.

Preferably, the hard coating further includes a second layer. A composition formula of the second layer is M(BₓC_{y}N_{1-x-y}). In the composition formula of M(BₓC_{y}N_{1-x-y}), M is one or more elements selected from the group consisting of W, Mo, Nb and V, and x, y are respective atomic ratios of B, C, and a relational expression of 0 < 1-x-y is satisfied.

W, Mo, Nb and V are elements that generate oxides having lubricity. Therefore, the second layer containing the element M which is one or more of these elements is provided separately from the first layer, which can further improve the lubricity of the hard coating. As a result, the adhesion resistance of the hard coating can be further improved. Moreover, multilayering by the first and second layers can further improve hardness of the coating.

The element M may be one element selected from the group consisting of W, Mo, Nb and V, or may be two or more elements selected from the group. The atomic ratio x of B is 0 ≤ x ≤ 0.20, 0.05 ≤ x is preferable, and x ≤ 0.15 is preferable. The atomic ratio y of C is 0 ≤ y ≤ 0.30, 0.03 ≤ y is preferable, and y ≤ 0.20 is preferable, more preferably, y ≤ 0.15.

In the hard coating, a thickness of the second layer is preferably equal to or less than a thickness of the first layer.

Since the second layer contains the element M that generates the oxide having lubricity and does not contain Zr and Hf, it is a layer having a smaller strength than that of the first layer, so that a crack or the like easily occurs. Therefore, forming the second layer inferior in strength to be thinner than the first layer can suppress a decrease in strength of the whole hard coating while exerting the lubricity by the second layer.

In the hard coating, preferably, a thickness of the first layer is 1 nm or more and 150 nm or less, and a thickness of the second layer is 1 nm or more and 150 nm or less.

If the thickness of each of the first and second layers is less than 1nm, sufficient increase in hardness by the multilayering cannot be obtained. Moreover, since the functions of the respective layers cannot be sufficiently exerted, the wear resistance decreases. Therefore, the thickness of each of the layers is 1 nm or more, preferably 2 nm or more, and more preferably 5 nm or more.

On the other hand, if the thickness of each of the layers exceeds 150 nm, the hardness of the coating also decreases, so that the wear resistance decreases.
Therefore, the thickness of each of the layers is 150 nm or less, preferably 50 nm or less, and more preferably 30 nm or less.

The thickness of each of the first and second layers takes an arbitrary value in the above-described ranges, and the values may be different from each other or the same. However, as described above, setting the thickness of the second layer equal to or less than that of the first layer can suppress the decrease in strength of the hard coating.

In the hard coating, preferably, a relational expression of 0 ≤ x ≤ 0.20 is satisfied in the first layer.

By setting the atomic ratio x of B to 0 or more, B and N bond in the coating to form boron nitrite (BN) which is a solid lubricant. As a result, the adhesion resistance of the coating can be further improved. In order to sufficiently exert this effect, preferably, the atomic ratio x is 0.05 ≤ x.

On the other hand, if the atomic ratio x of B exceeds 0.20, the coating is amorphized, and the wear resistance decreases. Therefore, the atomic ratio x is x ≤ 0.20, and preferably, x ≤ 0.15.

In the hard coating, preferably, a relational expression of 0 ≤ y ≤ 0.30 is satisfied in the first layer.

Since setting the atomic ratio y of C to 0 or more allows a metal carbide to be formed in the coating, the metal carbide having a friction coefficient reduced more than that of a metal nitride, the wear resistance of the coating can be further improved. Preferably, the atomic ratio y is 0.03 ≤ y.

On the other hand, if the atomic ratio y exceeds 0.30, free carbon in the coating increases, and the hardness of the coating decreases, so that the wear resistance decreases. Therefore, the atomic ratio y is y ≤ 0.30, preferably y ≤ 0.20, and more preferably y ≤ 0.15.

The hard coating-covered member according to the embodiment comprises a base material which is a blade edge portion of a cutting tool or a metal mold and the hard coating which is formed on the base material.

In the hard coating-covered member, the hard coating having the excellent adhesion resistance to the workpiece of the titanium-based metal is formed on the based material. Therefore, the adhesion between the hard coating and the workpiece can be suppressed in the processing of the titanium-based metal, and the wear resistance can be improved.

### (First Embodiment)

### [Hard coating-covered member]

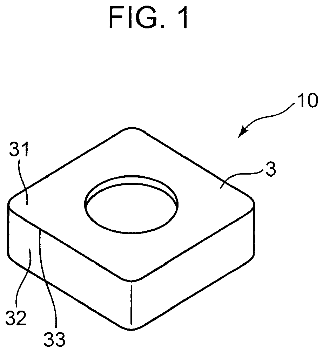

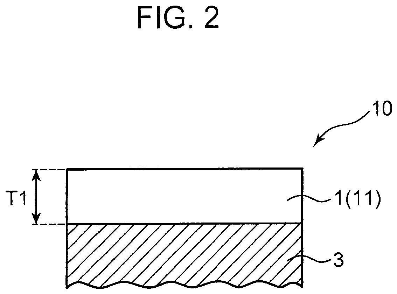

Next, mainly referring to FIGS. 1 and 2, a hard coating-covered member 10 according to a first embodiment of the present invention will be described. FIG. 1 is a perspective view showing a whole structure of the hard coating-covered member 10. FIG. 2 is a partial cross-sectional view of the hard coating-covered member 10.

The hard coating-covered member 10 is a blade edge portion (an insert) of a cutting tool for cutting and processing a material to be cut made of a titanium-based metal such as pure titanium, a titanium alloy and the like. The hard coating-covered member 10 is attached to a tip portion of a handle (a shank) (not shown) of the cutting tool to be used. The hard coating-covered member 10 comprises a base material 3 having a quadrilateral planar shape and a hard coating 1 which is coated on a surface of the base material 3.

The base material 3 is made of a material such as a superhard metal alloy, an iron-based alloy having a metal carbide, a cermet, a high-speed tool steel, and the like. The base material 3 has a rake face 31 and a flank face 32. The rake face 31 is a portion that bites into the material to be cut and rakes the same. The flank face 32 is a portion that is flanked in order to avoid contact with the material to be cut. A portion where the rake face 31 connects to the flank face 32 is a cutting edge 33.

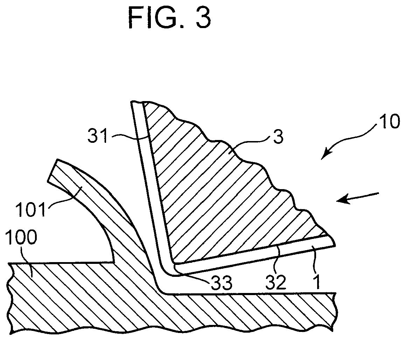

FIG. 3 shows the cutting and processing of a material to be cut 100 when the hard coating-covered member 10 is used as an insert. As shown in FIG. 3, by moving the insert so that the cutting edge 33 bites into a surface of the material to be cut 100, the surface of the material to be cut 100 is cut. A chip 101 generated by this process passes on the rake face 31. The cutting edge 33 of the insert is a portion receiving a load by contact with the material to be cut 100, so that a temperature rise at the cutting edge 33 becomes large. This facilitates progress of the wear of the hard coating 1 formed as a coating layer on the base material 3 in the cutting edge 33.

### [Hard coating]

Next, referring to FIG. 2, the hard coating 1 according to the first embodiment of the present invention will be described. The hard coating 1 is formed on a surface of the base material 3 as a wear resistant coating. The hard coating 1 is formed on the surface of the base material 3 by a physical vapor deposition (PVD) method such as arc ion plating (AIP), spattering and the like.

The hard coating 1 is configured by a first layer 11 which is formed on the base material 3. The first layer 11 has a thickness T1 of 0.5 µm or more in order to effectively function as the wear resistant coating. Moreover, in order to restrain a defect or peeling-off of the coating film during cutting because of too large thickness, the thickness T1 of the first layer 11 is preferably 10 µm or less, more preferably 5 µm or less, and still more preferably 3 µm or less. However, the thickness T1 of the first layer 11 is not limited to the above-described range. Since the hard coating 1 is a single-layer coating film which is configured by only the first layer 11, the thickness T1 of the first layer 11 is the same as the thickness of the whole hard coating 1.

A composition formula of the first layer 11 is Zr_{1-a-b}HfₐMg_{b}(BₓC_{y}N_{1-x-y}). In this composition formula, a is an atomic ratio of Hf, b is an atomic ratio of Mg, x is an atomic ratio of boron (B), and y is an atomic ratio of carbon (C). A sum of the atomic ratios of Zr, Hf and Mg, and a sum of the atomic ratios of B, C and nitrogen (N) are each 1. Therefore, the atomic ratio of Zr is 1-a-b, and the atomic ratio of N is 1-x-y(> 0). Hereinafter, a range of an introduction amount of respective elements and effects by introduction of each of the elements will be described.

Mg is introduced so that the atomic ratio b is 0.05 or more (0.05 ≤ b). Mg is a metal that does not dissolve in Ti. Therefore, as shown in FIG. 3, in the case when the material to be cut 100 made of a titanium-based metal is cut and processed by the hard coating-covered member 10, the adhesion between the hard coating 1 and the material to be cut 100 can be suppressed. As a result, the wear of the hard coating 1 due to the adhesion can be suppressed. In this manner, in view of improvement of the adhesion resistance of the hard coating 1 to the material to be cut 100, more preferably, the atomic ratio b of Mg is 0.08 or more (0.08 ≤ b), and still more preferably, 0.10 or more (0.10 ≤ b).

Mg is introduced so that the atomic ratio b is 0.30 or less (b ≤ 0.30). This can restrain the coating from being softened due to excessively contained Mg, and a decreasing of the wear resistance is suppressed. In this manner, in view of effective suppression of softening of the coating, more preferably, the atomic ratio b of Mg is 0.25 or less (b ≤ 0.25), still more preferably, 0.20 or less (b ≤ 0.20).

The hard coating 1 contains at least one of Zr and Hf, and contains N. Zr and Hf are transition metal elements in group 4 of the periodic table like Ti, and generate more thermodynamically stable nitrides (ZrN, HfN) and oxides (ZrO₂, HfO₂) as compared with Ti. Specifically, ZrN and HfN are compounds having standard free energy of formation which is smaller than that of TiN, and having lower reactivities compared with TiN. Therefore, as shown in FIG. 3, in the case when the material to be cut 100 made of a titanium-based metal is cut and processed by the hard coating-covered member 10, ZrN and HfN in the hard coating 1 are restrained from reacting in an active newly-formed surface exposed to a surface of the material to be cut 100. This can suppress the wear of the hard coating 1.

The atomic ratio a of Hf is 0 or more and 0.95 or less (0 ≤ a ≤ 0.95). A total atomic ratio of Zr and Hf ((1-a-b) + a)) is 0.70 or more and 0.95 or less in view of a total atomic ratio (1) of Zr, Hf and Mg and the atomic ratio of Mg (0.05 ≤ b ≤ 0.30). The atomic ratio of any one of Zr and Hf may be 0, and neither of the atomic ratios may be 0. That is, only Zr may be contained in the hard coating 1, only Hf may be contained in the hard coating 1, or both Zr and Hf may be contained in the hard coating 1.

B is introduced so that the atomic ratio x is 0 or more, preferably, 0.05 or more. This allows B and N to bond in the coating and form boron nitrite (BN) which is a solid lubricant. As a result, the adhesion resistance of the hard coating 1 to the material to be cut 100 is further improved, so that the wear resistance is further improved. On the other hand, in order not to excessively introduce B, the atomic ratio x is set to 0.20 or less (x ≤ 0.20). This can restrain the coating from being amorphized due to excessively contained B, and a decreasing of the wear resistance is suppressed. In this manner, in view of effective suppression of amorphization of the coating, more preferably, the atomic ratio x of B is 0.15 or less (x ≤ 0.15). Moreover, B is not an essential element in the hard coating 1, and may not be necessarily introduced (x = 0).

C is introduced so that the atomic ratio y is 0 or more, preferably, 0.03 or more. Since this allows a metal carbide having a smaller friction coefficient than a metal nitride to be formed in the coating, the wear resistance of the coating can be further improved. On the other hand, in order not to excessively introduce C, the atomic ratio y is set to 0.30 or less (y ≤ 0.30). This can suppress a decrease in hardness due to an increase of free carbon in the coating, and a decrease in wear resistance is suppressed. In this manner, in view of effective suppression of the decrease in hardness due to the increase of free carbon, more preferably, the atomic ratio y of C is 0.20 or less (y ≤ 0.20), and still more preferably, 0.15 or less (y ≤ 0.15). Similarly to B, C is not an essential element in the hard coating 1, and may not be necessarily introduced (y = 0).

### [Method for forming a hard coating]

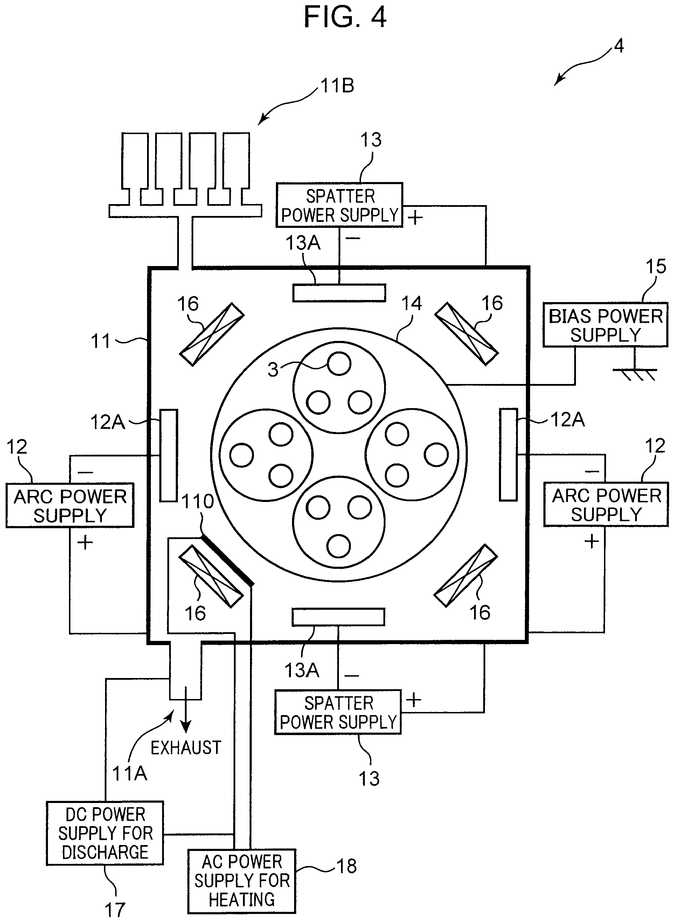

Next, referring to FIG. 4, a procedure for forming the hard coating 1 on the base material 3 will be described. FIG. 4 shows a device configuration of a coating formation device 4 used for forming the hard coating 1. First, referring to FIG. 4, the configuration of the coating formation device 4 will be described.

The coating formation device 4 comprises a chamber 11, a plurality of (two) arc power supplies 12 and spatter power supplies 13, a base material stage 14, a bias power supply 15, heaters 16, a DC power supply for discharge 17 and an AC power supply for heating a filament 18. In the chamber 11, there are provided a gas exhaust port 11A to evacuate an inside of the chamber 11 and a gas supply port 11B to supply a coating forming gas and a rare gas into the chamber 11. An arc evaporation source 12A where a target is disposed is connected to the arc power supplies 12. A spatter evaporation source 13A where a target is disposed is connected to the spatter power supplies 13. The base material stage 14 is rotatable, and has a support surface to support the base material 3 which is a coating formation object. The bias power supply 15 applies a negative bias to the base material 3 through the base material stage 14. The plurality of (four) heaters 16 are disposed inside the chamber 11 to be used for heating the base material 3.

Next, a coating formation procedure of the hard coating 1 on the base material 3 will be described. First, the base material 3 is prepared. Next, the base material 3 is cleaned in a cleaning liquid such as ethanol and the like. Thereafter, as shown in FIG. 4, the base material 3 after cleaning is set on the base material stage 14 inside the chamber 11. On the other hand, the target for coating formation obtained by mixing Zr, Hf and Mg at a predetermined ratio is set in the arc evaporation sources 12A.

Next, an exhaust from the gas exhaust port 11A reduces a pressure inside the chamber 11 to a predetermined pressure to put it into a vacuum state. Then, Ar gas is introduced into the chamber 11 from the gas supply port 11B, and the base material 3 is heated to a predetermined temperature by the heaters 16. The surface of the base material 3 is subjected to etching by Ar ions for a predetermined time. This removes an oxide coating or the like formed on the surface of the base material 3, which improves an adhesion of the hard coating 1 to the base material 3.

Next, nitrogen gas, mixed gas of nitrogen gas and methane gas, mixed gas of nitrogen gas and boron fluoride gas or mixed gas of nitrogen gas, methane gas and boron fluoride gas are introduced into the chamber 11 from the gas supply port 11B. By causing a predetermined arc current to flow, the target set in the arc evaporation source 12A is evaporated, and the base material stage 14 is rotated at a predetermined rotational speed. This allows the evaporated target to adhere to the surface of the base material 3 to thereby form the hard coating 1. During the coating formation, a predetermined negative bias is applied to the base material 3 by the bias power supply 15. A coating formation speed of the hard coating 1 is adjusted by a condition of the arc current and a condition of the rotational speed of the base material stage 14, and a coating formation time is adjusted so that a coating thickness of the hard coating 1 reaches a desired value. In the case where the hard coating 1 containing B is formed, boron fluoride may be used as a boron source as described above. However, the present invention is not limited thereto, and a target for coating formation containing B may be used.

After the coating thickness of the hard coating 1 has reached the desired value, the supply of the arc current and the rotation of the base material stage 14 are stopped. Thereafter, the chamber 11 is opened to the atmosphere, and the base material 3 after coating formation is taken out of the chamber 11. By the above-described procedure, the formation of the hard coating 1 on the base material 3 is performed.

### (Second Embodiment)

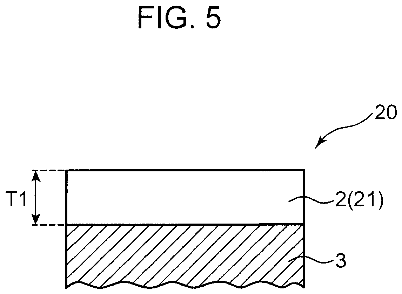

Next, referring to FIG. 5, a hard coating-covered member 20 and a hard coating 2 according to a second embodiment of the present invention will be described. The hard coating-covered member 20 according to the second embodiment is a blade edge portion of a cutting tool as with the first embodiment. The above-described hard coating-covered member 20 comprises the base material 3 made of a superhard metal alloy or the like and the hard coating 2 which is formed on the base material 3. Moreover, as with the first embodiment, the hard coating 2 is formed by depositing a target on the base material 3, the target being evaporated using the coating formation device 4 (FIG. 4). However, in the hard coating 2 according to the second embodiment, as described below, a composition thereof is different from that of the hard coating 1 of the first embodiment in that, in addition to Zr, Hf and Mg, the hard coating 2 further contains a metal element (M) that generates an oxide having lubricity such as tungsten (W), molybdenum (Mo), niobium (Nb), vanadium (V) and the like.

The hard coating 2 is configured by a first layer 21 which is formed on the base material 3. The first layer 21 has the same thickness T1 as that of the first layer 11 in the first embodiment. A composition formula of the first layer 21 is Zr_{1-a-b-c}HfₐMg_{b}M_{c}(BₓC_{y}N_{1-x-y}). In this composition formula, "M" is one or more elements selected from the group consisting of W, Mo, Nb and V. "a" is an atomic ratio of Hf. "b" is an atomic ratio of Mg. "c" is an atomic ratio of M. "x" is an atomic ratio of B. "y" is an atomic ratio of C. A sum of the atomic ratios of Zr, Hf, Mg and M, and a sum of the atomic ratios of B, C and N are each 1. Therefore, an atomic ratio of Zr is 1-a-b-c, and an atomic ratio of N is 1-x-y (>0). The element M is uniformly dissolved in the hard coating 2.

The respective atomic ratios a, b, x, y of Hf, Mg, B, C are adjusted in the same ranges as the ranges in the first embodiment (0 ≤ a ≤ 0.95, 0.05 ≤ b ≤ 0.30, 0 ≤ x ≤ 0.20, 0 ≤ y ≤ 0.30). Moreover, effects by introduction of these elements are also as described in the first embodiment. Moreover, as with the first embodiment, the first layer 21 contains at least one of Zr and Hf, and contains N. Hereinafter, a range of an introduction amount of the element "M" and effects by an introduction of the element "M" will be described.

M (W, Mo, Nb, V) is introduced so that the atomic ratio c exceeds 0 (0 < c). W, Mo, Nb, V are each an element that generates an oxide having lubricity. Therefore, when the material to be cut 100 is cut and processed using the hard coating-covered member 20, the oxide having lubricity is generated in a wear surface of the hard coating 2. This suppresses an adhesion between the hard coating 2 and the material to be cut 100, and wear of the hard coating 2 is further suppressed. In this manner, in order to increase the lubricity of the hard coating 2 and improve the adhesion resistance, the atomic ratio c is preferably 0.10 or more (0.10 ≤ c), more preferably 0.15 or more (0.15≤ c), and still more preferably 0.20 or more (0.20 ≤ c).

M is introduced so that the atomic ratio c is 0.50 or less (c ≤ 0.5). Excessively containing M relatively reduces the amounts of ZrN and HfN which are stable compounds, so that the wear speed of the coating becomes fast. In contrast, setting the atomic ratio c to 0.50 or less can suppress the wear of the coating. In this manner, in view of assuring the amount of the stable nitride (ZrN, HfN) to suppress the excessive wear speed, the atomic ratio c is preferably 0.40 or less (c ≤ 0.40), and more preferably 0.30 or less (c ≤ 0.30).

M may be one element of W, Mo, Nb and V, or may be two or more elements thereof. Moreover, W, Mo, Nb and V are different in melting points of the respective oxides. Therefore, the type of M is preferably selected in view of a load received by the cutting tool during cutting and a temperature rise. Specifically, the oxide of V has a lower melting point than those of the oxides of W, Mo and Nb. Therefore, in the case where the load received by the cutting tool during cutting is low, and the rise in blade edge temperature is small, the hard coating 2 containing V may be used. On the other hand, in the case where the load received by the cutting tool during cutting is high, and the rise in blade edge temperature are large, the hard coating 2 containing W, Mo, Nb, the oxide of which have high melting points, may be used. Particularly, in the cutting and processing of the material to be cut 100 made of a titanium-based metal, the rise in blade edge temperature is large, and thus the hard coating 2 containing W, Mo, Nb is preferably used.

### (Modifications)

### [Modification of first embodiment]

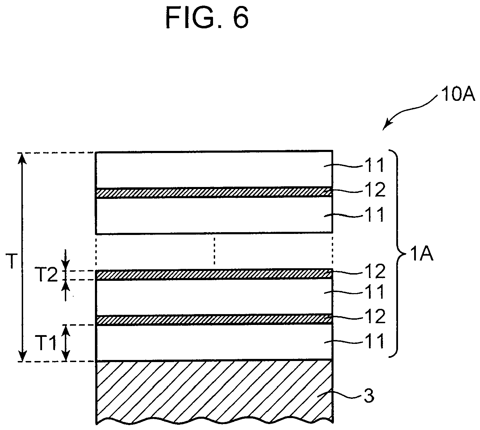

Next, referring to FIG. 6, a hard coating-covered member 10A and a hard coating 1A according to a modification of the first embodiment will be described. The hard coating-covered member 10A has a structure in which the hard coating 1A is formed on the base material 3 as with the first embodiment. The hard coating 1A according to this modification further has a second layer 12 in addition to the first layer 11, and is a lamination type hard coating where the first and second layers 11 and 12 are alternately laminated as shown in FIG. 6. The above-described alternately laminated structure can further improve the hardness of the coating.

A composition formula of the second layer 12 is M(BₓC_{y}N_{1-x-y}). In this composition formula, x is an atomic ratio of B, and y is an atomic ratio of C. Moreover, since a sum of the atomic ratios of B, C and N is 1, an atomic ratio of N is 1-x-y (> 0).

In the second layer 12, the respective atomic ratios x and y of B and C are adjusted to the same ranges as those in the first layer 11 (0 ≤ x ≤ 0.20, 0 ≤ y ≤ 0.30), and N is contained. "M" is one or more elements selected from the group consisting of W, Mo, Nb and V. That is, M may be one element of W, Mo, Nb and V, or may be two or more elements thereof. In this manner, further having the second layer 12 containing M that generates an oxide having lubricity improves the adhesion resistance of the coating. Moreover, multilayering by the first and second layers 11 and 12 can improve hardness of the coating more than that in the case of the single coating.

The thickness T2 of the second layer 12 is different from the thickness T1 of the first layer 11, and specifically, is equal to or less than the thickness T1 of the first layer 11. Since the second layer 12 contains the element M that generates the oxide having lubricity and does not contain Zr and Hf, it is a layer having a smaller strength than that of the first layer 11, so that a crack or the like easily occurs. Therefore, forming the second layer 12 inferior in strength to be thinner than the first layer 11 can suppress a decrease in strength of the whole hard coating 1A while exerting the lubricity by the second layer 12.

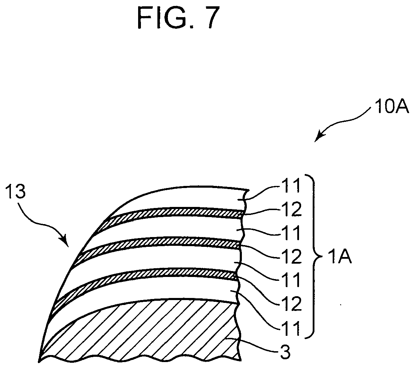

FIG. 7 shows the wear of the hard coating 1A in the cutting edge 33 (FIG. 3) during cutting and processing. As shown in FIG. 7, since the hard coating 1A is worn in an oblique direction during cutting and processing, a laminated cross-section 13 of the first and second layers 11 and 12 is exposed. This facilitates progress of the oxidization of W, Mo, Nb, V in the second layer 12. Therefore, when the thickness T2 of the second layer 12 is too large, a crack occurs in the second layer 12 which becomes fragile due to the oxidization, and a strength of the whole hard coating 1A decreases. In order to prevent this, the thickness T2 of the second layer 12 is equal to or less than the thickness T1 of the first layer 11.

The thicknesses T1 and T2 of the first and second layers 11 and 12 are each 1 nm or more and 150 nm or less. If the thicknesses T1 and T2 of the first and second layers 11 and 12 are each less than 1 nm, sufficient increase in hardness by the multilayering cannot be obtained. Moreover, since the functions of the respective layers cannot be sufficiently exerted, the wear resistance decreases. Therefore, the thicknesses T1 and T2 of the first and second layers 11 and 12 are each 1 nm or more, more preferably 2 nm or more, and still more preferably 5 nm or more. Moreover, if the thicknesses T1 and T2 of the first and second layers 11 and 12 each exceed 150 nm, the hardness of the coating also decreases, so that similarly, the wear resistance decreases. Therefore, the thicknesses T1 and T2 of the first and second layers 11 and 12 are each 150 nm or less, more preferably 50 nm or less, still more preferably 30 nm or less.

As shown in FIG. 6, the first layer 11 may be formed in contact with the base material 3, or the second layer 12 may be formed in contact with the base material 3. On an outermost surface (a surface on the opposite side of the base material 3) of the hard coating 1A, the same layer as the layer in contact with the base material 3 (the first layer 11 in FIG. 6) may be formed, or the different layer from the layer in contact with the base material 3 may be formed.

Moreover, the hard coating 1A is not limited to the above-described aspect, but various laminated structures can be employed in accordance with purposes. For example, the hard coating 1A is not limited to the multilayer structure which is configured by the first and second layers 11 and 12, but may further include a third layer having a composition different from those of the first and second layers 11 and 12, and have a multilayer structure which is configured by the first to third layers.

A thickness T of the whole hard coating 1A is adjusted to 0.5 µm or more and 10 µm or less, similarly to the thickness T1 of the first layer 11 in the first embodiment. The number of times of lamination of the first and second layers 11 and 12 in the hard coating 1A is designed so that the thickness T of the whole hard coating 1A is in the above-described range in view of the thicknesses of the respective layers. Here, the "number of times of lamination" is counted as one when one first layer 11 and one second layer 12 are laminated. In order to exert the respective functions of the first and second layers 11 and 12 in the laminated state maximally, the number of times of lamination is preferably two or more. That is, preferably, the respective thicknesses of the first and second layers 11 and 12 are made thin to increase the number of times of lamination.

Next, referring to FIG. 4, a procedure for forming the hard coating 1A on the base material 3 will be described. While the hard coating 1A is basically formed by a procedure similar to that of the first embodiment, it is different in that the first and second layers 11 and 12 are alternately laminated.

First, the base material 3 is cleaned, and the base material 3 after cleaning is set on the base material stage 14. Moreover, a target for ground layer such as Zr and the like is set in the arc evaporation source 12A. A first target obtained by mixing Zr, Hf, Mg at a predetermined ratio is set in one of the arc evaporation source 12A and the spatter evaporation source 13A, while a second target of a simple substance of Nb, V, Mo, W or obtained by mixing these elements at a predetermined ratio is set in the other.

Next, the inside of the chamber 11 is decompressed to a predetermined pressure, and then, Ar gas is supplied into the chamber 11. Moreover, the base material 3 is heated to a predetermined temperature by the heaters 16. The surface of the base material 3 is subjected to etching processing by Ar ions for a predetermined time.

Next, coating forming gas such as nitrogen gas, methane gas, boron fluoride and the like is introduced into the chamber 11 so that the pressure therein becomes a predetermined pressure. Under the predetermined condition of the arc current, the target for ground layer is evaporated, and the base material stage 14 is rotated. This allows a ground layer (ZrN) of a predetermined thickness to be formed on the base material 3. This ground layer is formed to improve the adhesion between the base material 3 and the laminated film of the first and second layers 11 and 12.

Next, in a state where the temperature of the base material 3 and the gas pressure are kept, the arc evaporation sources 12A and the spatter evaporation sources 13A simultaneously discharge electricity to evaporate the first and second targets, and the base material stage 14 is rotated. This allows the base material 3 to alternately pass the arc evaporation sources 12A and the spatter evaporation sources 13A with the first and second targets set, and the first and second layers 11 and 12 to be alternately laminated on the base material 3. By the above-described procedure, the hard coating 1A is formed on the base material 3.

### [Modification of second embodiment]

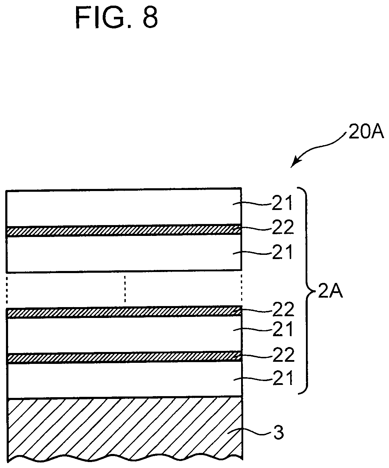

Next, referring to FIG. 8, a hard coating-covered member 20A and a hard coating 2A according to a modification of the second embodiment will be described. The hard coating-covered member 20A has a structure in which the hard coating 2A is formed on the base material 3 as with the second embodiment. The hard coating 2A according to this modification further has a second layer 22 in addition to the first layer 21, and is a lamination type hard coating where the first and second layers 21 and 22 are alternately laminated as shown in FIG. 8. That is, the hard coating 2A is an alternately laminated film of the first layer 21 and the second layer 22 as with the modification of the first embodiment. The hard coating 2A basically has a configuration similar to that of the modification of the first embodiment (FIG. 6) except for the composition of the first layer 21, and is similarly formed.

A composition formula of the second layer 22 is M(BₓC_{y}N_{1-x-y}) as with the modification of the first embodiment. In this composition formula, x is an atomic ratio of B, and y is an atomic ratio of C. Moreover, since a sum of the atomic ratios of B, C and N is 1, an atomic ratio of N is 1-x-y (> 0).

In the second layer 22, the respective atomic ratios x and y of B and C are adjusted to the same ranges as those in the first layer 21 (0 ≤ x ≤ 0.20, 0 ≤ y ≤ 0.30), and N is contained. M is one or more elements selected from the group consisting of W, Mo, Nb and V, and may be one element selected from the group, or may be two or more elements. In this manner, by further having the second layer 22 containing M that generates the oxide having lubricity and not containing Zr and Hf, the adhesion resistance of the coating is further improved. Moreover, multilayering by the first and second layers 21 and 22 can improve hardness of the coating more than that in the case of the single coating.

The thickness of the second layer 22 is equal to or less than the thickness of the first layer 21 as with the modification of the first embodiment. Moreover, the thickness of each of the first and second layers 21 and 22 is in a range of 1 nm or more and 150 nm or less as with the modification of the first embodiment.

In the first and second embodiments and the modifications thereof, the cases where the base material of the hard coating-covered member is the blade edge portion (the insert) of the cutting tool are described, but the present invention is not limited thereto. The base material may be applied to other jigs and tools such as a metal mold for press, a metal mold for forging, a metal mold for molding, and the like.

### Examples

In order to confirm the effects of the present invention with respect to the wear resistance of the hard coating, the following experiments were performed.

### [First example]

First, a hard coating having a composition of No. 1 shown in the following table 1 was prepared in the following procedure. A cutting tool and a superhard test piece having a mirror surface for cross-section evaluation (a 13 mm square, a thickness 5 mm) were subjected to an ultrasonic cleaning in an ethanol, and were set inside the coating formation device 4. Moreover, a target for coating formation adjusted to the composition of No. 1 was set in the arc evaporation source 12A.

Next, the inside of the chamber 11 was evacuated to 5 × 10⁻³ Pa. Next, Ar gas was introduced into the chamber 11, the base material 3 was heated to 500°C by the heaters 16, and then, the surface of the base material 3 was etched by Ar ions for two minutes.

Thereafter, nitrogen gas was introduced until the pressure inside the chamber 11 became 4 Pa. Operation was performed at an arc current of 150A, and the base material 3 was rotated at a rotational speed of 5rpm, by which the hard coating was formed on the base material 3. During the coating formation, a bias of -30 V was applied to the base material 3 by the bias power supply 15. Moreover, a coating formation time was adjusted so that the thickness of the whole hard coating became 3 µm.

Moreover, similarly to No. 1, hard coatings having compositions of Nos. 2 to 36 were also prepared by a similar procedure. As the target for coating formation, targets containing Zr, Hf and Mg which are elements other than C, N, and in some examples, further containing M and B were used. Moreover, as a comparative example, a target of TiAIN was also prepared. As the coating forming gas, nitrogen gas or mixed gas of nitrogen gas and methane gas was used. The atomic ratio of M in each of Nos. 31 to 34 of table 1 was a total value of atomic ratios of a plurality of elements.

As the cutting tool, an insert was used. As the material to be cut, Ti-6Al-4V was used. A cutting test was conducted under the following condition using an insert in which the hard coating was formed to evaluate the wear amount.

For evaluation of the wear amount, measurement of the wear width was carried out at 1000 m. The measurement of the wear width was performed by installing the insert so that a flank face and an objective lens were parallel, photographing the same with an optical microscope (magnification: 300), and performing the measurement at five positions in one visual field to calculate an average value (µm).

### <Cutting condition>

Material to be cut: Ti-6Al-4V
Tool: CNMG432, Quality of material K313
Cutting speed: 45 m/minute
Feed: 0.15 mm/REV
Cutting depth: 2.0 mm
Lubrication: wet (emulsion)

**[Table 1]**

| No | ATOMIC RATIO | | | TYPE OF M | ATOMIC RATIO | | | | HARDNESS (HV) | WEAR WIDTH (µm) |
|---|---|---|---|---|---|---|---|---|---|---|
| | Zr | Hf | Mg | | M | B | C | N | | |
| 1 | 0.9 | 0.1 | 0 | - | - | 0 | 0 | 1 | 2200 | 180 |
| 2 | 0.90 | 0.00 | 0.10 | - | - | 0 | 0 | 1 | 2350 | 85 |
| 3 | 0.80 | 0.10 | 0.10 | - | - | 0 | 0 | 1 | 2400 | 70 |
| 4 | 0.30 | 0.60 | 0.10 | - | - | 0 | 0 | 1 | 2600 | 65 |
| 5 | 0.45 | 0.45 | 0.10 | - | - | 0 | 0 | 1 | 2700 | 55 |
| 6 | 0.60 | 0.30 | 0.10 | - | - | 0 | 0 | 1 | 2650 | 60 |
| 7 | 0.00 | 0.90 | 0.10 | - | - | 0 | 0 | 1 | 2600 | 70 |
| 8 | 0.60 | 0.34 | 0.06 | - | - | 0 | 0 | 1 | 2650 | 70 |
| 9 | 0.55 | 0.30 | 0.15 | - | - | 0 | 0 | 1 | 2450 | 75 |
| 10 | 0.60 | 0.20 | 0.20 | - | - | 0 | 0 | 1 | 2300 | 75 |
| 11 | 0.45 | 0.25 | 0.30 | - | - | 0 | 0 | 1 | 2300 | 80 |
| 12 | 0.40 | 0.20 | 0.40 | - | - | 0 | 0 | 1 | 2000 | 230 |
| 13 | 0.80 | 0.10 | 0.10 | - | - | 0.05 | 0 | 0.95 | 2400 | 65 |
| 14 | 0.80 | 0.10 | 0.10 | - | - | 0.1 | 0 | 0.9 | 2400 | 60 |
| 15 | 0.80 | 0.10 | 0.10 | - | - | 0.2 | 0 | 0.8 | 2250 | 70 |
| 16 | 0.80 | 0.10 | 0.10 | - | - | 0.3 | 0 | 0.7 | 2000 | 140 |
| 17 | 0.80 | 0.10 | 0.10 | - | - | 0 | 0.1 | 0.9 | 2350 | 65 |
| 18 | 0.80 | 0.10 | 0.10 | - | - | 0 | 0.25 | 0.75 | 2400 | 75 |
| 19 | 0.80 | 0.10 | 0.10 | - | - | 0 | 0.4 | 0.6 | 1800 | 160 |
| 20 | 0.80 | 0.10 | 0.10 | - | - | 0.03 | 0.12 | 0.85 | 2450 | 70 |
| 21 | 0.80 | 0.10 | 0.10 | - | - | 0.05 | 0.05 | 0.9 | 2500 | 55 |
| 22 | 0.55 | 0.20 | 0.20 | Nb | 0.05 | 0.00 | 0.00 | 1.00 | 2800 | 65 |
| 23 | 0.50 | 0.20 | 0.20 | Nb | 0.10 | 0.00 | 0.00 | 1.00 | 2800 | 55 |
| 24 | 0.40 | 0.20 | 0.20 | Nb | 0.20 | 0.00 | 0.00 | 1.00 | 3000 | 50 |
| 25 | 0.35 | 0.20 | 0.20 | Nb | 0.25 | 0.00 | 0.00 | 1.00 | 3000 | 40 |
| 26 | 0.10 | 0.20 | 0.20 | Nb | 0.50 | 0.00 | 0.00 | 1.00 | 3200 | 60 |
| 27 | 0.25 | 0.05 | 0.10 | Nb | 0.60 | 0.00 | 0.00 | 1.00 | 1700 | 150 |
| 28 | 0.65 | 0.10 | 0.10 | V | 0.15 | 0.00 | 0.00 | 1.00 | 2800 | 60 |
| 29 | 0.65 | 0.10 | 0.10 | Mo | 0.15 | 0.00 | 0.00 | 1.00 | 3100 | 50 |
| 30 | 0.65 | 0.10 | 0.10 | W | 0.15 | 0.00 | 0.00 | 1.00 | 3100 | 45 |
| 31 | 0.60 | 0.10 | 0.10 | W, Nb | 0.20 | 0.00 | 0.00 | 1.00 | 3000 | 40 |
| 32 | 0.60 | 0.10 | 0.10 | Mo, V | 0.20 | 0.00 | 0.00 | 1.00 | 2900 | 55 |
| 33 | 0.60 | 0.10 | 0.10 | W. V | 0.20 | 0.00 | 0.00 | 1.00 | 3000 | 55 |
| 34 | 0.60 | 0.10 | 0.10 | W, Nb | 0.20 | 0.05 | 0.05 | 0.90 | 3100 | 40 |
| 35 | 0.60 | 0.10 | 0.10 | Nb | 0.20 | 0.10 | 0.00 | 0.90 | 2900 | 45 |
| 36 | TiAlN | | | | | | | | 2500 | 200 |

Hereinafter, referring to table 1, the above-described experiment results will be described. First, experiment results of Nos. 1 to 12 and No. 36 will be described. In No. 1, since Mg was not contained, the adhesion between the hard coating and the material to be cut was large, and the wear width was large (180 µm). On the other hand, in No. 12, since Mg was excessively contained, the coating was softened, and the wear width was large (230 µm). Moreover, in No. 36, the hard coating made of TiAlN was used, and the wear width was large due to the adhesion between the hard coating and the material to be cut (200 µm). In contrast, in Nos. 2 to 11, the atomic ratios of Mg were adjusted to a range of 0.05 to 0.30, and the wear resistance was largely improved as compared with the results of Nos. 1, 12, and 36.

Next, experiment results of Nos. 13 to 21 will be described. In Nos. 13 to 21, the atomic ratios of Zr, Hf, Mg were fixed, and the atomic ratios of C, B, N were varied. In Nos. 13 to 15 (the atomic ratio of B: 0 to 0.2), the wear width was smaller than that of No. 16 (the atomic ratio of B: 0.3). This was because in No. 16, B was excessively contained, so that the hardness of the coating decreased, and the wear resistance decreased. On the other hand, in Nos. 17, 18 (the atomic ratio of C: 0 to 0.3), the wear width was smaller than that of No. 19 (the atomic ratio of C: 0.4). This was because in No. 19, C was excessively contained, so that the coating was softened, and the wear resistance decreased.

Next, experiment results of Nos. 22 to 35 will be described. In Nos. 22 to 27, Nb was used as the element M, and the atomic ratio of Nb was varied. In Nos. 28 to 30, the elements other than Nb were used as the element M. In Nos. 31 to 34, two or more elements were combined as the element M. In No. 35, B was contained. In No. 27, since Nb was excessively contained (the atomic ratio of M: 0.6), the amounts of ZrN and HfN decreased, so that thermal stability of the coating was lost, and the wear width increased as compared with those in Nos. 22 to 26 (the atomic ratio of M: 0 to 0.50). Moreover, it is clear from the comparison between No. 10 and Nos. 22 to 26, further introduction of the element M into the hard coating improved the wear resistance.

### [Second example]

First, a hard coating having a composition of No. 1 shown in the following table 2 was prepared in the following procedure. A cutting tool and a superhard test piece having a mirror surface for cross section evaluation (a 13 mm square, a thickness 5 mm) were subjected to an ultrasonic cleaning in an ethanol, and were set inside the coating formation device 4. Moreover, Zr was set in the arc evaporation source 12A as a target for ground layer. Moreover, a first target having the composition of the first layer of No.1 was set in one of the arc evaporation sources 12A and the spatter evaporation sources 13A, and a second target having the composition of the second layer of No. 1 was set in the other.

Next, the inside of the chamber 11 was evacuated to 5 × 10⁻³ Pa. Next, Ar gas was introduced into the chamber 11, the base material 3 is heated to 500°C by the heaters 16, and then, the surface of the base material 3 was etched by Ar ions for two minutes.

Thereafter, nitrogen gas was introduced until the pressure inside the chamber 11 became 4 Pa. Operation was performed by AIP at the arc current of 150A, and the base material stage 14 was rotated, by which a ZrN layer (100 nm) was formed as the ground layer on the base material 3.

Next, in a state where the temperature of the base material 3 and the gas pressure were kept, the arc evaporation sources 12A and the spatter evaporation sources 13A simultaneously discharged electricity to evaporate the first and second targets, and the base material stage 14 was rotated. This allowed the hard coating with the first and second layers alternately laminated to be formed on the base material 3 (thickness 3 µm). As the coating forming gas, nitrogen gas or mixed gas of nitrogen gas and methane gas was used, the rotation speed of the base material 3 was 5 rpm, and the bias applied to the base material 3 during coating formation was -30 V.

Moreover, similarly to No. 1, hard coatings having compositions of Nos. 2 to 26 were also prepared by a similar procedure. As the first target, targets containing Zr, Hf and Mg which are elements other than C, N, and in some examples, further containing B were used. As the second target, targets containing M, and in some examples, further containing B were used.

As the cutting tool, an insert was used. As the material to be cut, Ti-6Al-4V was used. A cutting test was conducted in the following condition using an insert in which the hard coating had been formed to evaluate the wear amount.

For the evaluation of the wear amount, measurement of the wear width was carried out at 1000 m. The measurement of the wear width was performed by installing the insert so that a flank face and an objective lens were parallel, photographing the same with an optical microscope (magnification: 300), and performing the measurement at five positions in one visual field to calculate an average value (µm).

### <Cutting condition>

Material to be cut: Ti-6Al-4V
Tool: CNMG432, Quality of material K313
Cutting speed: 45 m/minute
Feed: 0.15 mm/REV
Cutting depth: 2.0 mm
Lubrication: wet (emulsion)

**[Table 2]**

| No | FIRST LAYER | | | | | | | SECOND LAYER | | | | | HARDNESS (HV) | WEAR WIDTH (µm) |
|---|---|---|---|---|---|---|---|---|---|---|---|---|---|---|
| | ATOMIC RATIO | | | | | | COATING THICKNESS | ATOMIC RATIO | | | | COATING THICKNESS (nm) | | |
| | Zr | Hf | Mg | B | C | N | | M | B | C | N | | | |
| 1 | 0.8 | 0.1 | 0.1 | 0 | 0 | 1 | 1.5 | Nb | 0 | 0 | 1 | 1 | 2400 | 100 |
| 2 | 0.8 | 0.1 | 0.1 | 0 | 0 | 1 | 2 | Nb | 0 | 0 | 1 | 2 | 2700 | 60 |
| 3 | 0.8 | 0.1 | 0.1 | 0 | 0 | 1 | 3 | Nb | 0 | 0 | 1 | 3 | 2900 | 50 |
| 4 | 0.8 | 0.1 | 0.1 | 0 | 0 | 1 | 5 | Nb | 0 | 0 | 1 | 5 | 3100 | 55 |
| 5 | 0.8 | 0.1 | 0.1 | 0 | 0 | 1 | 10 | Nb | 0 | 0 | 1 | 10 | 2950 | 50 |
| 6 | 0.8 | 0.1 | 0.1 | 0 | 0 | 1 | 25 | Nb | 0 | 0 | 1 | 25 | 2700 | 65 |
| 7 | 0.8 | 0.1 | 0.1 | 0 | 0 | 1 | 50 | Nb | 0 | 0 | 1 | 50 | 2550 | 70 |
| 8 | 0.8 | 0.1 | 0.1 | 0 | 0 | 1 | 75 | Nb | 0 | 0 | 1 | 75 | 2100 | 90 |
| 9 | 0.8 | 0.1 | 0.1 | 0 | 0 | 1 | 100 | Nb | 0 | 0 | 1 | 100 | 2000 | 130 |
| 10 | 0.8 | 0.1 | 0.1 | 0 | 0 | 1 | 150 | Nb | 0 | 0 | 1 | 120 | 1800 | 120 |
| 11 | 0.8 | 0.1 | 0.1 | 0 | 0 | 1 | 10 | Nb | 0.1 | 0 | 0.9 | 10 | 2800 | 50 |
| 12 | 0.8 | 0.1 | 0.1 | 0 | 0 | 1 | 10 | Nb | 0 | 0.1 | 0.9 | 10 | 3000 | 55 |
| 13 | 0.8 | 0.1 | 0.1 | 0 | 0 | 1 | 25 | Nb | 0 | 0 | 1 | 2 | 3000 | 65 |
| 14 | 0.8 | 0.1 | 0.1 | 0 | 0 | 1 | 25 | Nb | 0 | 0 | 1 | 5 | 3000 | 50 |
| 15 | 0.8 | 0.1 | 0.1 | 0 | 0 | 1 | 25 | Nb | 0 | 0 | 1 | 10 | 3100 | 55 |
| 16 | 0.8 | 0.1 | 0.1 | 0 | 0 | 1 | 25 | Nb | 0 | 0 | 1 | 15 | 2950 | 55 |
| 17 | 0.8 | 0.1 | 0.1 | 0 | 0 | 1 | 25 | V | 0 | 0 | 1 | 5 | 2850 | 65 |
| 18 | 0.8 | 0.1 | 0.1 | 0 | 0 | 1 | 25 | Mo | 0 | 0 | 1 | 5 | 3000 | 55 |
| 19 | 0.8 | 0.1 | 0.1 | 0 | 0 | 1 | 15 | W | 0 | 0 | 1 | 5 | 3100 | 55 |
| 20 | 0.8 | 0.1 | 0.1 | 0 | 0 | 1 | 15 | Nb0.50, W0.50 | 0 | 0 | 1 | 5 | 3100 | 45 |
| 21 | 0.8 | 0.1 | 0.1 | 0 | 0 | 1 | 15 | Mo0.50, W0.50 | 0 | 0 | 1 | 5 | 3200 | 45 |
| 22 | 0.8 | 0.1 | 0.1 | 0 | 0 | 1 | 15 | Nb0.50. V0.10. W0.40 | 0 | 0 | 1 | 5 | 2900 | 50 |
| 23 | 0.8 | 0.1 | 0.1 | 0 | 0 | 1 | 15 | Mo0.40, V0.20, W0.40 | 0 | 0 | 1 | 5 | 2950 | 50 |
| 24 | 0.8 | 0.1 | 0.1 | 0.1 | 0.1 | 0.8 | 20 | Nb | 0 | 0 | 1 | 10 | 3000 | 45 |
| 25 | 0.8 | 0.1 | 0.1 | 0.15 | 0 | 0.85 | 20 | Nb | 0 | 0 | 1 | 10 | 2950 | 50 |
| 26 | 0.8 | 0.1 | 0.1 | 0 | 0.25 | 0.75 | 20 | Nb | 0 | 0 | 1 | 10 | 2500 | 60 |

Hereinafter, referring to table 2, the above-described experiment results will be described. In Nos. 1 to 10, Zr0.80Hf0.10Mg0.10N was the first layer, and NbN was the second layer, which were alternately laminated, and the coating thickness of each of the layers was varied. In Nos. 11, 12, the atomic ratios of B, C in the second layer were varied. In Nos. 13 to 16, the first layer and the second layer had different coating thicknesses from each other. In Nos. 17 to 23, in the second layer, the elements other than Nb were contained as the element M, and two or more elements were contained. In Nos. 24 to 26, the atomic ratios of B, C and N were varied in the first layer.

In Nos. 2 to 7 (the coating thickness: 2 to 50 nm), since the performances of the respective layers in the laminated coating were sufficiently exerted, and decrease in hardness was small, the wear amounts were improved as compared with No. 1 and Nos. 8 to 10. From the comparison between No. 6 and Nos. 14 to 16, setting the thickness of the second layer equal to or less than the thickness of the first layer further improved the wear amount.

## Claims

1. A hard coating to be formed on a base material, including:
a first layer represented by a composition formula of Zr_{1-a-b}HfₐMg_{b}(BₓC_{y}N_{1-x-y}), wherein
in the composition formula of Zr_{1-a-b}HfₐMg_{b}(BₓC_{y}N_{1-x-y}), a, b, x, y are respective atomic ratios of Hf, Mg, B, C, and relational expressions of 0 ≤ a ≤ 0.95, 0.05 ≤ b ≤ 0.30 and 0 < 1-x-y are satisfied.

2. The hard coating according to claim 1, further including a second layer represented by composition formula of M(BₓC_{y}N_{1-x-y}), wherein
in the composition formula of M(BₓC_{y}N_{1-x-y}), M is one or more elements selected from the group consisting of W, Mo, Nb and V, x, y are respective atomic ratios of B, C, and a relational expression of 0 < 1-x-y is satisfied.

3. The hard coating according to claim 2, wherein
a thickness of the second layer is equal to or less than a thickness of the first layer.

4. The hard coating according to claim 2 or 3, wherein
a thickness of the first layer is 1 nm or more and 150 nm or less, and a thickness of the second layer is 1 nm or more and 150 nm or less.

5. A hard coating to be formed on a base material, including:
a first layer represented by a composition formula of Zr_{1-a-b-c}HfₐMg_{b}M_{c}(BₓC_{y}N_{1-x-y}) and containing at least one of Zr and Hf, wherein
in the composition formula of Zr_{1-a-b-c}HfₐMg_{b}M_{c}(BₓC_{y}N_{1-x-y}), M is one or more elements selected from the group consisting of W, Mo, Nb and V, a, b, c, x, y are respective atomic ratios of Hf, Mg, M, B, C, and relational expressions of 0 ≤ a ≤ 0.95, 0.05 ≤ b ≤ 0.30, 0 < c and 0 < 1-x-y are satisfied.

6. The hard coating according to claim 5, wherein
a relational expression of 0 < c ≤ 0.50 is satisfied in the first layer.

7. The hard coating according to claim 5 or 6, further including a second layer represented by a composition formula of M(BₓC_{y}N_{1-x-y}), wherein
in the composition formula of M(BₓC_{y}N_{1-x-y}), M is one or more elements selected from the group consisting of W, Mo, Nb and V, x, y are respective atomic ratios of B, C, and a relational expression of 0 < 1-x-y is satisfied.

8. The hard coating according to claim 7, wherein
a thickness of the second layer is equal to or less than a thickness of the first layer.

9. The hard coating according to claim 7, wherein
a thickness of the first layer is 1 nm or more and 150 nm or less, and a thickness of the second layer is 1 nm or more and 150 nm or less.

10. The hard coating according to any one of claims 1 to 3, 5 and 6, wherein
a relational expression of 0 ≤ x ≤ 0.20 is satisfied in the first layer.

11. The hard coating according to any one of claims 1 to 3, 5 and 6, wherein
a relational expression of 0 ≤ y ≤ 0.30 is satisfied in the first layer.

12. A hard coating-covered member comprising:
a base material which is a blade edge portion of a cutting tool or a metal mold; and
the hard coating according to any one of claims 1 to 3, 5 and 6 which is formed on the base material.
